# EUROPEAN PATENT SPECIFICATION

(11) **EP 2 690 064 B1**
(45) Date of publication and mention of the grant of the patent: **15.05.2019**
(21) Application number: 12762958.2
(22) Date of filing: 23.03.2012
(51) Int. Cl.: C01B 33/06, B22F 9/00, H01L 35/14, H01L 35/34, C22C 23/00, B22F 9/06, C22C 1/04, H01L 35/22

(54) **INORGANIC-COMPOUND PARTICLES AND PROCESS FOR PRODUCING SAME**
PARTIKEL EINER ANORGANISCHEN VERBINDUNG UND VERFAHREN ZU IHRER HERSTELLUNG
PARTICULES D'UN COMPOSÉ INORGANIQUE ET LEUR PROCÉDÉ DE PRODUCTION

(30) Priority: 25.03.2011 JP 2011068559
(43) Date of publication of application: 29.01.2014
(73) Proprietor: National Institute for Materials Science, Tsukuba-shi, Ibaraki 305-0047 (JP); MITSUBA Corporation, Kiryu-shi Gunma 376-8555 (JP)
(72) Inventor: ISODA, Yukihiro, Ibaraki 305-0047 (JP); SHIODA, Naoki, Gunma 376-8555 (JP)
(74) Representative: V.O.
(86) International application number: PCT/JP2012/057497
(87) International publication number: WO 2012/133176

(56) References cited:
- WO-A1-2004/016375
- CN-A- 101 850 977
- JP-A- 2002 285 274
- JP-A- 2002 368 291
- JP-A- 2009 094 497
- YUKIHIRO ISODA ET AL: "Fabrication and Thermoelectric Properties on Silicides Thermoelectric Materials with Eco-friendly", CERAMICS, JP, vol. 40, no. 7, 1 January 2005 (2005-01-01), pages 534-537, XP008172333,
- YUKIHIRO ISODA ET AL.: 'Fabrication and Thermoelectric Properties on Silicides Thermoelectric Materials with Eco-friendly' CERAMICS vol. 40, no. 7, 2005, pages 534 - 537, XP008172333

## Description

### TECHNICAL FIELD

The present invention relates to a method for producing inorganic compound particles and, in particular, a Mg-Si-based compound. The present invention also relates to inorganic compound particles produced by the above-mentioned method.

### BACKGROUND ART

Conventionally, the production method of inorganic compound particles which include multiple elements generally utilizes the following processes.
An ingot, obtained by directly melting multiple raw materials, is crushed by using stamp mill and ball-mill (see Non-Patent Literature 1 [NPL 1]).

Other than the method described above, the atomizing method (the water atomization method, the gas atomization method, etc.), the centrifugal atomization method, the mechanical alloying method, or the like, are known as a method of producing inorganic compound particles .

The atomizing method is a method in which particles of a compound can be obtained, whereby particles are formed by spraying the melt liquid of raw materials. In the centrifugal atomization method, the particles of compound can be obtained by the centrifugal force which drops melt liquid of the raw materials into the rotating plate. In the mechanical alloying method, particles of a compound can be obtained by alloying the raw material particles using a ball mill.

### [Related Art Document]

### [Patent Literature]

JP 2002-285274 A discloses a method for the production of a Mg-Si based thermoelectric material: Mg powder and Si powder are mixed at an atomic ratio of Mg to Si of 2:1, to which mixture dopant powder, such as aluminum powder, is also mixed. The powder mixture is heated to and held at a temperature within the range of the melting point of magnesium to 800°C, whereby Mg₂Si forms by the reaction of the molten Mg and Si particles and the dopant dissolves into the molten Mg and is substituted for part of the Mg or Si in the Mg₂Si crystal structure.

### [Non-Patent Literature]

[NPL 1] Nishida I, et al., Thermoelectric conversion engineering, Fundamentals and Applications, Realize Science & Engineering Center, May 30, 2001

### DISCLOSURE OF INVENTION

### [Problems to be Solved by the Invention]

For example, in the case of Mg₂Si or Mg₂Ge, the boiling point of Mg (1090°C) is close to the melting points of Mg₂Si (1085°C) or Mg₂Ge (1117°C).

Thus, variation of the composition of the inorganic compound by the vaporization of Mg, contamination of impurities, oxidization, or the like, in the conventional methods (atomizing method, centrifugal splaying method, or the like) can occur when Mg₂Si (or Mg₂Ge) is synthesized by melting and mixing Mg and Si (or Ge).

Furthermore, when the particle size of the raw particles materials is large, producing particles of an inorganic compound with homogeneity is difficult for the mechanical alloying method. On the other hand, countermeasures against dust explosion have to be taken in a case where the particle size of the raw particles is small.

Because of the reasons described above, to obtain inorganic compound (for example, Mg₂Si and Mg₂Ge) particles with a particularly large particle size (for example, several 10 microns or more), the raw materials are synthesized only by directly melting in a pressurized, airtight container to avoid the vaporization of Mg and then the obtained ingot is crushed. The foregoing is believed to be common knowledge in the present technical field.

However, the production process which produces ingots and then crushes them is cumbersome and increases the production cost.

The present invention is made under the circumstances described above. The purpose of the present invention is to provide inorganic compound particles which are a composite including Si and Mg, and a method to produce the same.

### [Means for Solving the Problems]

The first aspect of the present invention is a method of producing inorganic compound particles which are a composite including Si and Mg, the method comprising the steps of:
heating a raw material comprising (i) first raw-material particles comprising Si as a major element, and (ii) second raw-material particles comprising Mg as a major element, at a temperature equal to or higher than 650°C and lower than 945.6°C, thereby impregnating a melt liquid of the second raw-material particles into the first raw-material particles; and
synthesizing the inorganic compound particles through a synthesis reaction between the elements comprised in said first and second raw-materials particles which takes place in the first raw-material particles, wherein
the first raw-material particles and the second raw-material particles are mixed in the raw material in an atomic ratio corresponding to the atomic ratio of the said major element, Si, and the said major element, Mg, within the inorganic compound particles,
the inorganic compound particles are represented by the formula Mg₍₂₋ₓ₎A₍ₓ₎Si_{(1-y)}A'_{y} where A and A' are different one or more dopant elements as defined below and x+y is equal to or less than 0.2,
the particle size of the first raw-material particles is greater than 53µm and less than 500µm,
the dopant elements are selected from the group consisting of B, P, Al, Sb, and Bi and are added to the first raw-material particles, and
the particle size of the inorganic compound particles is greater than 25µm and equal to or less than 1mm after the step of synthesizing the inorganic compound particles.

When the raw material is heated at the above-indicated temperature (which is lower than the melting point of the inorganic compound and equal to or above the eutectic crystal temperature between the region-II (liquid-solid phase range) and the region-I (solid phase range) on the phase diagram of the above-mentioned major elements of the above-mentioned raw-material particles, the liquid of the second raw-material particles infiltrates into the above-mentioned first raw-material particles.

In the method of producing inorganic compound particles, the first raw-material particles may be a mixture of plural types of particles which consist of different elements.

In the method of producing inorganic compound particles, the first raw-material particles may be a composite of particles which consist of different elements.

A second aspect of the present invention is a particle of an inorganic compound obtained by the method according to the first aspect of the present invention, wherein the surface of the inorganic compound particle is covered by protuberances in a raised fabric shape, which protuberances are minute relative to the particle size of the inorganic compound particle.

The inorganic compound particle may have a bi-layer structure with a central part and an outer peripheral part, wherein the element constituting the first raw-material particles is the major constituent element of the central part, and the elements constituting the first and second raw-material particles are the major constituent elements of the outer peripheral part.

The inorganic compound particle may have a uniform composition extending from an outer peripheral part to a central part in the inorganic compound particle.

### [Effects of the Invention]

The first aspect of the present invention is an unconventional and novel chemical synthesis method based on the finding that particles of an inorganic compound can be obtained by a synthetic reaction in a particle after absorption by the melt liquid of one element into the particle containing the other element.

In this method, production cost can be easily reduced. There is no need for the above-mentioned crushing process at all in the method of the present invention, since the core raw particles (which are the first raw-material particles) can be turned into particles of the inorganic compound, even if the particle sizes of the inorganic compound particles are several dozens of microns or more.

In addition, variation of the composition of the particles, and the contamination of impurities, as well as oxidation can be suppressed in the method of the present invention, since the first raw-material particles are not melted.

In addition, the inorganic compound particles according to the second aspect of the present invention can have a multi-layered structure in which only the outer peripheral part of the particle (outer surface part) is made by the method of synthesis according to the present invention. Alternatively, the entire particle can have a uniform composition. The structure of the particles of the inorganic compound can be easily regulated by, for example, the size of the second raw-material particles, the heating temperature, or the heating time.

The size of the particle of the inorganic compound can be determined by the amount of the material (the second raw-material particles) absorbed into the first raw-material particles. Thus, if a needed particle diameter is set in advance, compound particles with the intended size can be obtained at a high yield by determining the size of the first raw-material particles and taking into account the synthesis condition.

Further, the specific surface area of the obtained compound particles is significantly increased since the surface of the compound particles is covered by nano-size protuberances in a raised fabric shape. Thus, particles having an excellent surface effect can be provided. In addition, each particle can be conjugated easily by the protuberances in a raised fabric shape, increasing the mechanical strength of the sintered compact.

### BRIEF DESCRIPTION OF THE DRAWINGS

FIG. 1 is a photograph showing an example of the process to produce inorganic compound particles by the method of the present invention. The photograph shows a heating container which is to be used in the method of production into which Mg granules have been placed.
FIG. 2 is a photograph showing the process continued from FIG. 1. The photograph shows the state where Si particles were placed on the Mg granules.
FIG. 3 provides X-ray diffraction profiles for the inorganic compound particles of the test numbers 3-03 to 3-08.
FIG. 4 is a scanning electron micrograph of the Si particles (whose particle sizes are from 106µm to 150µm) which are raw materials.
FIG. 5 is a scanning electron micrograph of the Si particles (whose particles sizes are from 53µm to 75µm) which are raw materials.
FIG. 6 is a scanning electron micrograph of the inorganic compound particles of the test number 4-05.
FIG. 7 is a scanning electron micrograph of the inorganic compound particles of the test number 4-05.
FIG. 8 is a scanning electron micrograph of the surface condition on the inorganic compound particles of the test number 4-05.
FIG. 9 is a composition image of a cross section of the inorganic compound particles of the test number 4-02.
FIG. 10 is a composition image of a cross section of the inorganic compound particle of the test number 4-02. The particle in FIG. 10 is unreacted.
FIG. 11 is a Si concentration distribution image of a cross section of the inorganic compound particle of the test number 4-02. The particle in FIG. 11 is unreacted.
FIG. 12 is a Mg concentration distribution image of a cross section of the inorganic compound particle of the test number 4-02. The particle in FIG. 12 is unreacted.
FIG. 13 is a composition image of a cross section of the particles of an inorganic compound of the test number 4-04. The particle in FIG.13 has reacted completely.
FIG. 14 is a Si concentration distribution image of a cross section of the inorganic compound particles of the test number 4-04.
FIG. 15 is a Mg concentration distribution image of a cross section of the inorganic compound particles of the test number 4-04..
FIG. 16 is a graph showing yields for inorganic compound particles of the test numbers 4-03 to 4-08.
FIG. 17 is a graph showing yields for inorganic compound particles of the test numbers 4-14 to 4-18.
FIG. 18 is a phase equilibrium diagram of Mg-Si.
FIG. 19 is a phase equilibrium diagram of Mg-Ge (not related to present invention).
FIG. 20 is a photograph showing the state of the inorganic compound particles of the test number 4-19 (not according to present invention) after heat treatment.
FIG. 21 is a graph showing yield of Mg₂Si particles of the test numbers 5-01 to 5-03. Sb, Bi, or Al is doped in Mg₂Si as a dopant element.

### BEST MODE FOR CARRYING OUT THE INVENTION

The method of producing particles of an inorganic compound represented by the formula Mg₍₂₋ₓ₎A₍ₓ₎Si_{(1-y)}A'_{y} where A and A' are different one or more dopant elements selected from the group consisting of B, P, Al, Sb, and Bi, and x+y is equal to or less than 0.2 concerns a method of producing inorganic compound particles that are a composite including the elements Si and Mg, which elements have different melting points.

In the method of the present invention, a raw material which includes (i) first raw-material particles containing Si as a major element (which element has a melting point (1412°C) equal to or higher than the melting point of the inorganic compound [hereinafter, referred to as "H point"]) and (ii) second raw-material particles containing Mg as a major element (which element has a melting point (650°C) lower than the H point), is heated at a temperature equal to or higher than 650°C and lower than 945.6°C.

As noted herein above, the inorganic compound is represented by the formula Mg₍₂₋ₓ₎A₍ₓ₎Si_{(1-y)}A'_{y} where A and A' are different one or more dopant elements selected from the group consisting of B, P, Al, Sb, and Bi, and x+y is equal to or less than 0.2.

As examples of the Mg-Si-based inorganic compound, Mg2Si, Mg₍₂₋ₓ₎SiBₓ(0<x≤0.2), Mg₂Si₍₁₋ₓ₎Pₓ(0<≤0.2), Mg₍₂₋ₓ₎Si₁Alₓ(0<x≤0.2), Mg₂Si₍₁₋ₓ₎Sbₓ(0<x≤0.2), and Mg₂Si₍₁₋ₓ₎Biₓ(0<x≤0.2) are named.

It is preferable that the inorganic compound is an intermetallic compound.

The first raw-material particles and the second raw-material particles are particles containing the constituting elements of the inorganic compound.

The first raw-material particles includes Si (which element has a melting point equal to or higher than the H point) as a major composition element among the constituent elements. Being the major element means that the content ratio of the element Si is the highest within the first raw-material particles.

One or more elements selected from the group consisting B, P, Al, Sb, and Bi may be added to the first raw-material particles.

The particle size of the first raw-material particles exceeds 53µm and less than 500µm.

If the particle size of the first raw-material particles is too small, they tend to be in an irregularly-shaped block form (see the test number 4-19 in Table 4). If the particle size of the first raw-material particles is excessively large, the composition of the inorganic compound particles tends to be uneven (see the test number 4-20 in Table 4).

The second raw-material particles include Mg (which element has a melting point lower than the H point) as a major composition element among the constituent elements.

An example of a combination of the first and second raw-material particles is shown in TABLE. 1

**[TABLE 1]**

| No. | Raw material | | Heating temperature (°C) | | Composition of inorganic compound particle |
|---|---|---|---|---|---|
| | First raw material | Second raw material | Lower limit temperature (°C or higher) | Upper limit temperature (lower than °C) | |
| 1-02 | Si | Mg | 650 | 945.6 | Mg₂Si |

The first raw-material particles may be constituted from the single element, Si. Alternatively, they may be a mixture of different types of particles having different elements to each other.

TABLES 2 and 3 show examples of the first raw-material particles and particles of an inorganic compound made of a mixture including several kinds of particles.

For example, if Si particles (major element) and B particles (dopant element) are used as the first raw-material particles and Mg particles are used as the second raw-material particles, then particles of the inorganic compound Mg₍₂₋ₓ₎SiBₓ(0<x≤0.2) can be obtained (see the test number 2-01 in TABLE 2).

If Si particles (major constituent element), B particles (dopant element), and Al particles (dopant element) are used as the first raw-material particles and Mg particles are used as the second raw-material particles, then particles of the inorganic compound Mg_{(2-x-y)}SiBₓAl_{y} (0<x+y≤0.2) can be obtained (see the test number 3-01 in TABLE 3).

Also, 3 or more kinds of dopant elements may be used.

**[TABLE 2]**

| No. | Raw material | | | Heating temperature (°C) | | Composition of inorganic compound particle |
|---|---|---|---|---|---|---|
| | First raw particle I | First raw particle II | Second raw particle | Lower limit temperature (°C or higher) | Upper limit temperature (lower than °C) | |
| | Main element | Minor element | | | | |
| 2-01 | Si | B | Mg | 650 | 945.6 | Mg₍₂₋ₓ₎SiBₓ(0<x≤0.2) |
| 2-02 | Si | P | Mg | 650 | 945.6 | Mg₂Si₍₁₋ₓ₎Pₓ(0<x≤0.2) |
| 2-03 | Si | Al | Mg | 650 | 945.6 | Mg₍₂₋ₓ₎Si₁Alₓ(0<x≤0.2) |
| 2-04 | Si | Sb | Mg | 650 | 945.6 | Mg₂Si₍₁₋ₓ₎Sbₓ(0<x≤0.2) |
| 2-05 | Si | Bi | Mg | 650 | 945.6 | Mg₂Si₍₁₋ₓ₎Biₓ(0<x≤0.2) |

**[TABLE 3]**

| No. | Raw material | | | | Heating temperature (°C) | | Composition of inorganic compound particle |
|---|---|---|---|---|---|---|---|
| | First raw particle I | First raw particle II | First raw particle III | Second raw particle | Lower limit temperature (°C or higher) | Upper limit temperature (lower than °C) | |
| | Main element | Minor element | Minor element | | | | |
| 3-01 | Si | B | Al | Mg | 650 | 945.6 | Mg_{(2-x-y)}SiBₓAl_{y}(0<x+y≤0.2) |
| 3-02 | Si | P | Al | Mg | 650 | 945.6 | Mg_{(2-y)}Si₍₁₋ₓ₎PₓAl_{y}(0<x+y≤0.2) |
| 3-03 | Si | Sb | Al | Mg | 650 | 945.6 | Mg_{(2-y)}Si₍₁₋ₓ₎SbₓAl_{y}(0<x+y≤0.2) |
| 3-04 | Si | Bi | Al | Mg | 650 | 945.6 | Mg_{(2-y)}Si₍₁₋ₓ₎BiₓAl_{y}(0<x+y≤0.2) |

Also, the first raw-material particles may be a composite of multiple kinds of particles having different elements to each other.

For example, if a composite of Si (major constituent element) and B is used as the first raw-material particles and Mg particles are used as the second raw-material particles, then particles of the inorganic compound Mg₍₂₋ₓ₎SiBₓ(0<x≤0.2) can be obtained.

If a composite of Si (major constituent element), B, and Al is used as the first raw-material particles and Mg particles are used as the second raw-material particles, then particles of the inorganic compound Mg_{(2-x-y)}SiBₓAl_{y} (0<x+y≤0.2) can be obtained (see the test number 3-01 in TABLE 3).

Also, 3 or more kinds of dopant elements may be used.

As explained above, in the case where a mixture or compound of multiple kinds of particles is used, particles of an inorganic compound containing the dopant elements can be obtained as the final product due to a synthetic reaction of 2 or more elements. Therefore, the obtained final product can be utilized directly.

The ratio between the first and second raw-material particles is set based on the atomic ratio corresponding to the atomic ratio of the major constituent elements Si and Mg in the intended inorganic compound particles.

For example, in the case where Mg₂Si concerns the intended inorganic compound particles, the ratio between the first and second raw-material particles can be set based on the atomic ratio corresponding to the atomic ratio of the major constituent elements of the first and second raw-material particles (i.e., Si and Mg, respectively) in the final product Mg₂Si.

Even in the case where the intended inorganic compound particles is a substance with 3 or more elements such as Mg₍₂₋ₓ₎SiBₓ(0<x≤0.2), the ratio between the first and second raw-material particles can be set based on the atomic ratio corresponding to the atomic ratio (Mg:Si=2-x:1) of the major constituent elements of the first and second raw-material particles (Mg and Si) in the final product Mg₍₂₋ₓ₎SiBₓ.

Even in the case where the intended inorganic compound particles is a substance with 4 or more elements such as Mg_{(2-x-y)}SiBₓAl_{y} (0<x+y≤0.2), the ratio between the first and second raw-material particles can be set based on the ratio corresponding to the atomic ratio (Mg:Si=2-x-y:1) of the major constituent elements of the first and second raw-material particles (Mg and Si) in the final product Mg_{(2-x-y)}SiBₓAl_{y}.

It is preferable that the ratio between the first and second raw-material particles is appropriately adjusted and set based on conditions, such as the composition of the intended inorganic compound, and whether the structure in the inorganic compound is a homogeneous single layer or multi-layered.

If the second raw-material particles are in excess of the molar ratio between the first and second raw-material particles, the melt liquid of the second raw-material particles cannot be absorbed into the first raw-material particles completely and thus, the un-absorbed melt liquid resides. Such residual second raw-material particles act as binders, and possibly cause formation of the particles in a block form. On the other hand, if the second raw-material particles are supplied insufficiently, the synthetic reaction within the first raw-material particles proceeds insufficiently such that the intended composition and a layered structure cannot be obtained.

Contrary to that, if the ratio of both raw-material particles is within the range of plus and minus 2% relative to the atomic ratio of each raw-material particle as determined from the composition or the structure of the intended inorganic compound, the intended inorganic compound can be obtained not in a block form (aggregated form).

Next, the raw material including the first and second raw-material particles is heated.

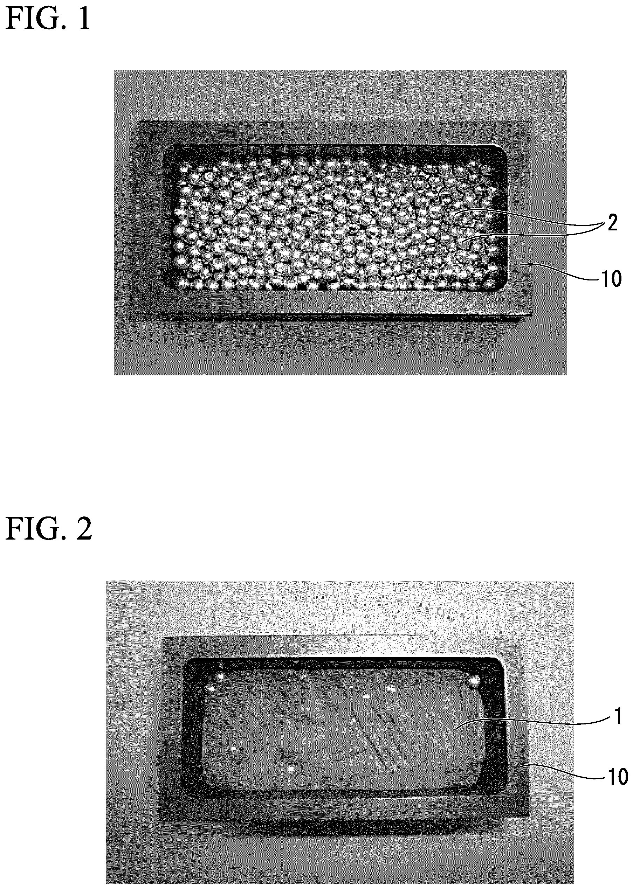

As shown in FIGS. 1 and 2, a heating container 10 (carbon board) made of carbon, or the like, can be used for heating the raw material.

For example, the second raw-material particles 2 made of Mg are evenly placed all over the bottom surface of the heating container 10 (see FIG. 1). Then, the first raw-material particles 1 made of Si are placed on the second raw-material particles 2 (see FIG. 2). It is preferable that the first raw-material particles 1 are placed on the second raw-material particles 2 to cover the second raw-material particles 2. Then, the heating container 10 is placed in a heating furnace to heat the raw material.

It is preferable that the heat treatment is performed in a non-oxidative atmosphere in order to avoid oxidization of the raw material.
For example, it is preferable that the heat treatment is performed under an inert gas atmosphere such as argon (Ar), or a mixed gas atmosphere in which hydrogen (H₂) is mixed with an inert gas.

The heat treatment temperature is equal to or higher than the eutectic temperature between the region-II (liquid-solid phase range) and the region-I (solid phase range) in a phase diagram of the major elements constituting both raw-material particles, and lower than the H point.

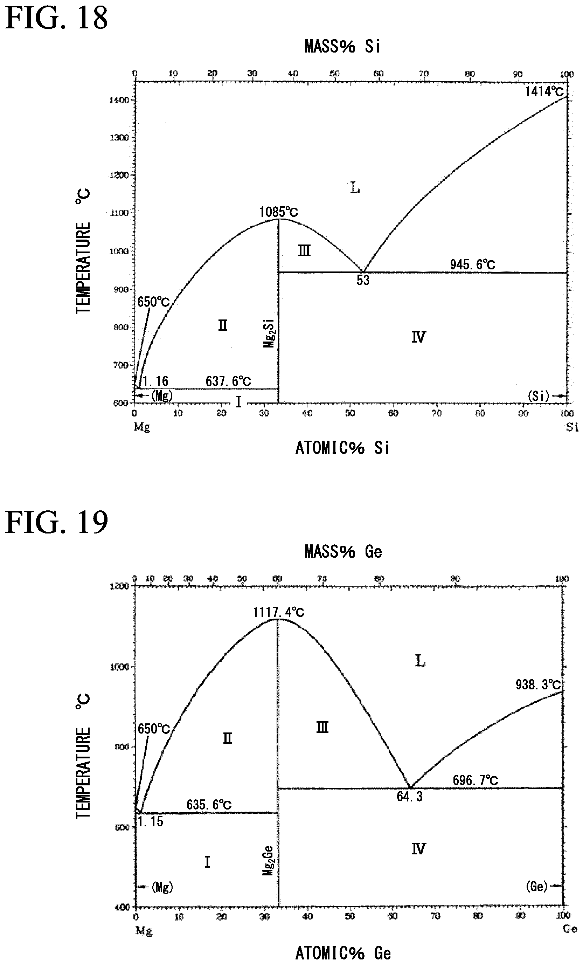

FIG. 18 is a binary system equilibrium diagram of Mg-Si which constitutes Mg₂Si as an example of the inorganic compound. In this phase diagram, the region-I corresponds to Mg (solid phase) and Mg₂Si (solid phase), the region-II corresponds to a liquid phase and Mg₂Si (solid phase), the region-III corresponds to a liquid phase and Si (solid phase), and the region-IV corresponds to Si (solid phase) and Mg₂Si (solid phase).

Therefore, in order to produce particles of the inorganic compound Mg₂Si from the first raw-material particles 1 (Si) and the second raw-material particles 2 (Mg), the heat treatment temperature is set to 650°C, which is the eutectic temperature of the regions I and II, or higher and lower than 945.6°C, which is the H point.

The second raw-material particles 2 (Mg) are melted by being heated at the above-mentioned temperature range. On the other hand, the first raw-material particles 1 (Si) are maintained at the solid-phase state. The melt liquid of the second raw-material particles 2 (Mg) is absorbed into the first raw-material particles 1 (Si). The particles of the inorganic compound (Mg₂Si) can be obtained by synthetic reaction between Mg and Si within the first raw-material particles 1.

The preferable heat treatment temperature depends on the particle diameters of the first raw-material particles 1 and second raw-material particles 2. When the size of the first raw-material particles 1 and second raw-material particles 2 are larger, it is preferable to set a higher heat treatment temperature. If the heat treatment temperature is high, the composition in the particles of the inorganic compound tends to become more homogeneous.

The heating time is, for example, 1 to 10 hours. It is preferable to set a longer heating time when the particle size of the first raw-material particles 1 and the second raw-material particles 2 are larger. The composition in the particles of the inorganic compound tends to become more homogeneous if the heating time is long.

The heat treatment temperature for a number of examples is shown in TABLES 1 to 3.

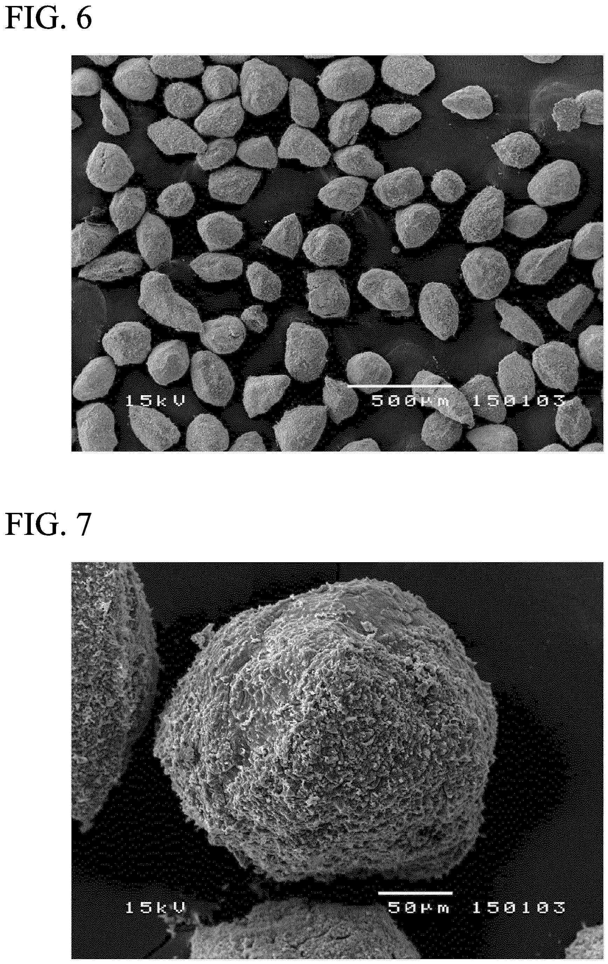

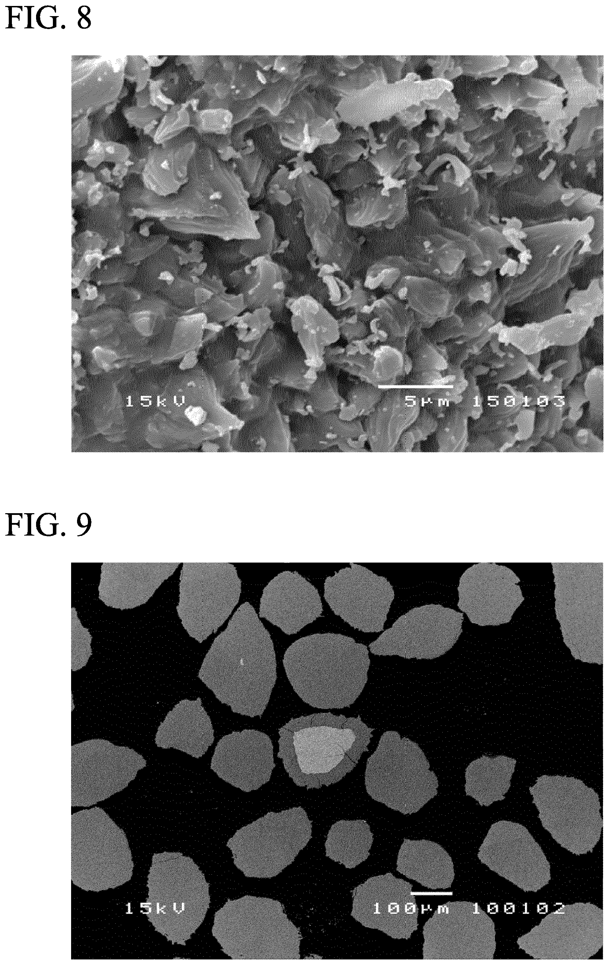

As shown in FIGS. 7 and 8, the surface of the inorganic compound particles produced by the above-mentioned method is covered in protrusions which are extremely small compared with the particle size of the inorganic compound. The protrusions are nano-size and cover the surface of the particles in a brushed shape.

It is expected that the specific surface area of the inorganic compound particles can be extremely enlarged by having this surface structure. Accordingly, the functional expression on the surface is easily expected.

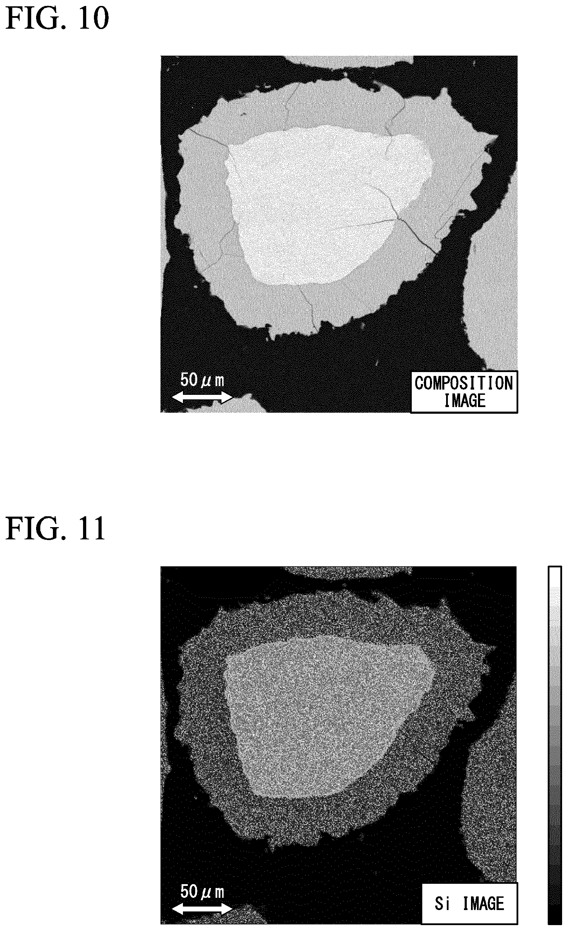

According to an embodiment of the present invention, inorganic compound particles having a multi-layered structure (bi-layer) can be produced: the bi-layer structure is constituted of a central part and an outer peripheral part (surface layer part). In this structure, the major constituent element of the central part is the element constituting the first raw-material particles. The major constituent elements of the outer peripheral part are the elements constituting the first and second raw-material particles. In the central part, the above-mentioned synthetic reaction does not occur. In the outer peripheral part, the synthesized material is formed (see FIGS 10 to 12, which are explained later).

In the inorganic compound particles with the multi-layered (bi-layer) structure, it is extremely important to have the above-described surface effect which is expressed by the second raw-material particles. Thus, it is expected that the inorganic compound particles with such a layered structure will be utilized in many purposes.

In addition, inorganic compound particles with a uniform composition can be obtained by performing heat treatment again, since the aforementioned layered structure is an intermediate structure. Alternatively, the multi-layered particles can be directly used for a certain purpose. Therefore, the utility of the inorganic compound particles can be extended.

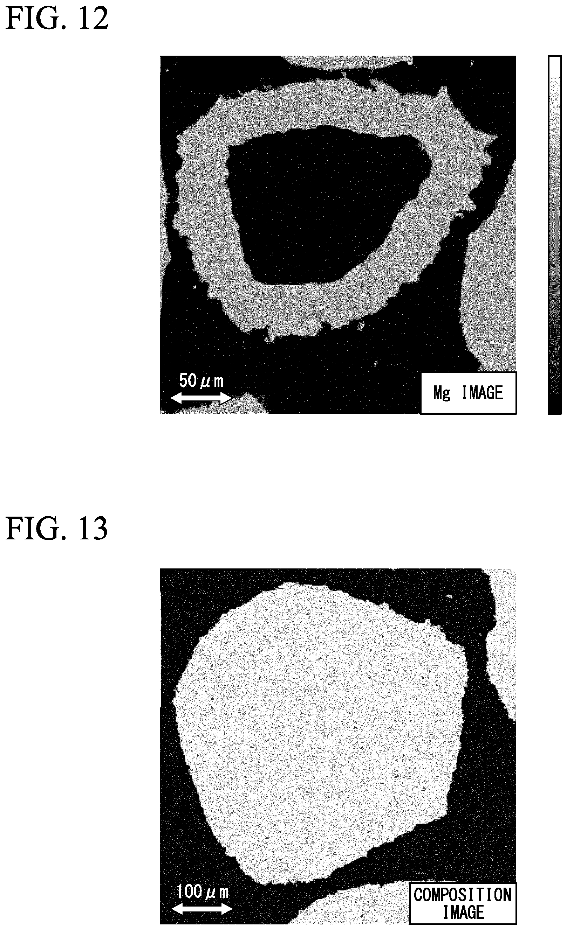

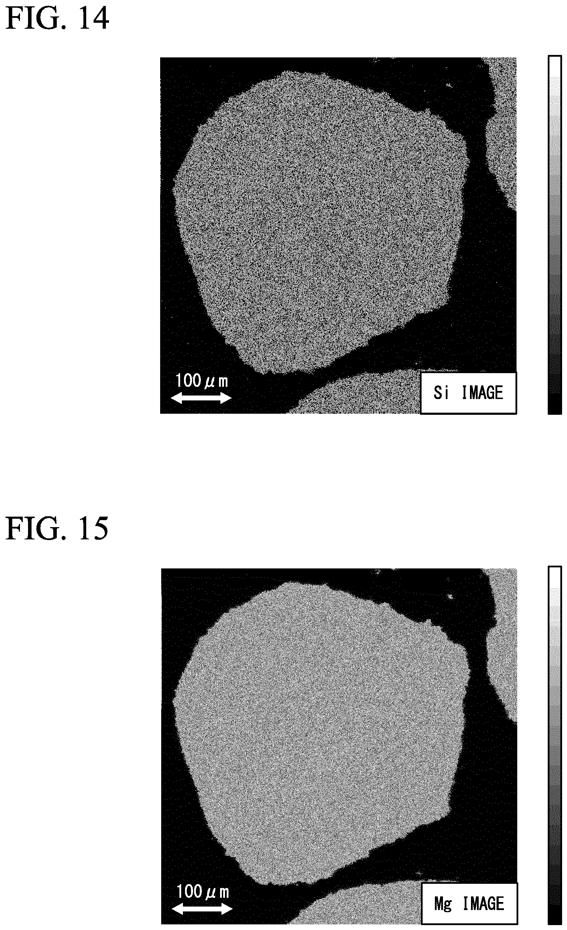

In accordance with an embodiment of the present invention, inorganic compound particles having a uniform composition extending from the outer peripheral to the center part can be produced (see FIGS 13 and 14, which are explained later).

As explained above, particles of an inorganic compound having different internal structures can be produced by the method of the present invention depending on the conditions chosen during their production.

FIG. 19 is a binary system equilibrium diagram of Mg-Ge which constitutes Mg₂Ge (not according to present invention). In this phase diagram, the region-I corresponds to Mg (solid phase) and Mg₂Ge (solid phase), the region-II corresponds to a liquid phase and Mg₂Ge (solid phase), the region-III corresponds to a liquid phase and Ge (solid phase), and the region-IV corresponds to Ge (solid phase) and Mg₂Ge (solid phase).

The heat treatment temperature is equal to or higher than the eutectic temperature between the region-II (liquid-solid phase range) and the region-I (solid phase range) in the phase diagram of the elements constituting both raw-material particles, and lower than the H point.

Therefore, in order to produce particles of Mg₂Ge (not according to present invention) from first raw-material particles 1 (Ge) and second raw-material particles 2 (Mg), the heat treatment temperature is set to 636°C, which is the eutectic temperature of the regions I and II, or higher and lower than 696°C, which is the H point.

The second raw-material particles (Mg) are melted by being heated at the above-mentioned temperature range. On the other hand, the first raw-material particles 1 (Ge) are maintained at the solid-phase state. The melt liquid of the second raw-material particles 2 (Mg) is adsorbed into the first raw-material particles 1 (Ge). The particles of Mg₂Ge (not according to the present invention) can be obtained by synthetic reaction between Mg and Ge within the first raw-material particles 1.

The production method of the present invention has been based on the finding that the first raw-material particles absorb the melt liquid of the other raw-material particles and the inorganic compound particles can be obtained by the synthetic reaction within the particles. This method is an unconventional and novel chemical synthesis.

Also, the core of raw-material particles (the first raw-material particles) can be turned into a composite kept in the particle-form. Thus, even if the particle diameter is several dozens of microns or larger, the inorganic compound particle can be obtained easily at low cost since the crushing process is not necessary at all.

Also, variation of the composition of the particles, and the contamination of impurities, as well as oxidation can be suppressed since the first raw-material particles do not melt.

In addition, the inorganic compound particles according to the second aspect of the present invention can have a multi-layered structure in which only the outer peripheral part of the particle (outer surface part) is made of the material synthesized according to the method of the present invention. Alternatively, the entire particle can have a uniform composition. The structure of the inorganic compound particles can be easily regulated by the size of the second raw-material particles, the heat treatment temperature, or the heating time.

The size of the inorganic compound particle can be determined by the amount of the material (the second raw-material particles) adsorbed into the first raw-material particles . Thus, if the necessary particle size of inorganic compound particles is set beforehand, compound particles with the desired size can be obtained with a high yield by determining the size of the first raw-material particles and taking into account the synthetic condition.

Further, the specific surface area of the obtained compound particles is significantly increased since the surface of the compound particles is covered by nano-size protuberances in a raised fabric shape. Thus, particles which have an excellent surface effect can be provided. In addition, each particle can be conjugated easily through jointing by the protuberances in a raised fabric shape, and thereby increasing the mechanical strength of the sintered compact.

### [Examples]

### [Example 1]

The first raw-material particles (Si particles), which are made of Si (purity: 99.9999%), and the second raw-material particles (Mg granules), which are made of Mg (purity: 99.9%), were prepared.

The Si particles were classified by sieve after crushing Si ingot in an alumina mortar. The classified particles having particle sizes exceeding 150µm and equal to or less than 250µm, exceeding 106µm and equal to or less than 150µm, exceeding 75µm and equal to or less than 106µm, exceeding 53µm and equal to or less than 75µm exceeding 38µm and equal to or less than 53µm, exceeding 20µm and equal to or less than 38µm were prepared by using sieves having openings of 500, 250, 150, 106, 75, 53, 38, and 20µm.

As the Mg granules, those having a particle size of about 3 to 8mm and those having a particle size of about 1 to 3mm were prepared.

The Mg granules and Si particles were weighted in order to have a mixing ratio of 2.02 to 1.00 (atomic ratio of Mg:Si).

As shown in FIG. 1, the Mg particles 2 were placed evenly all over the bottom surface of the heating container 10 (carbon board). Then, as shown in FIG. 2, the Si particles 1 were placed on the Mg particles 2 to cover the Mg particles 2. Then, the heating container 10 was placed in the heating furnace to perform heat treatment under the mixed gas atmosphere of 0.1 MPa argon-3% hydrogen. The heat treatment temperature was set to 700°C or 870°C. The heat treatment time was set to 2 or 4 hours when the heat treatment temperature was 870°C. It was set to 10 hours when the heat treatment temperature was 700°C.

After the heat treatment, a visual inspection, a sieve classification, and a phase analysis by X-ray diffraction was performed. Also, shape and surface observation, and composition analysis were performed by a scanning electron microscope. Results are shown in Table 4.

Based on the visual inspection results, it was demonstrated that the produced materials were all in a granular form, not in a block form, when the particle sizes of the Si particles exceeded 150µm and equaled 250µm or less, or when the particle sizes exceeded 106µm and equaled 150µm or less.

However, the produced materials were in a block form with particles being bonded together when the heat treatment temperature was 870°C and the particle size of the Si particles exceeded 38µm and equaled 53µm or less, or when the particle sizes exceeded 20µm and equaled 38µm or less.

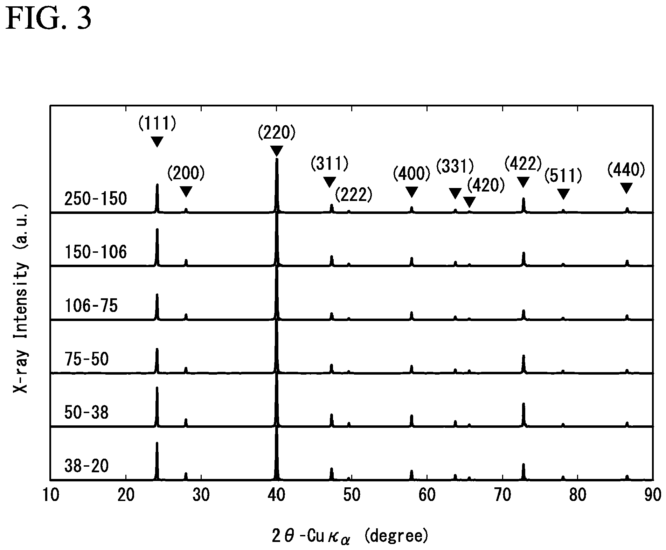

Results of the phase analysis of the produced materials by X-ray diffraction are shown in FIG. 3. The only obtained X-ray diffraction profile was an anti-fluorite structure, and the diffraction peaks originated from Mg or Si, or an unidentified diffraction peak was not observed. Therefore, it was confirmed that the produced materials were the single phase of Mg₂Si.

The Si particles before the heat treatment and the particles of the compound obtained by the heat treatment were observed by a scanning electron microscope.

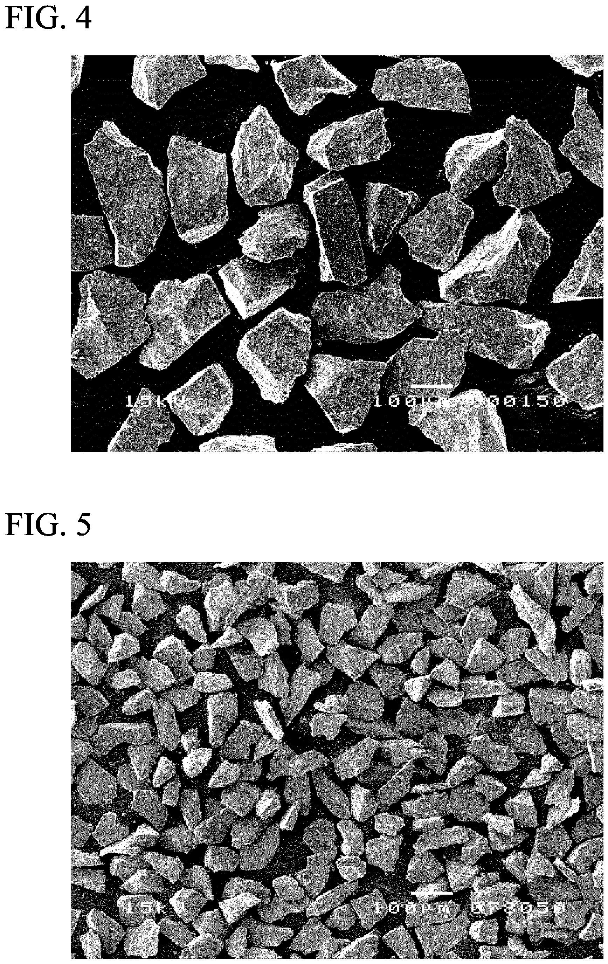

FIG. 4 shows Si particles having particle diameters that exceed 106µm and equal 150µm or less that were obtained after crushing in the above-mentioned mortar and classification. There were many particles which are of a flat form, a plate form, and a granular form.

FIG. 5 shows Si particles having particle sizes that exceed 53µm and equal 75µm or less. Similarly, many particles were included with a flat form, a plate form, and a granular form.

FIG. 6 shows the inorganic compound particles obtained by performing the heat treatment to the Si particles shown in FIG. 5 (particle diameter: exceeds 53µm and equals 75µm or less). The obtained inorganic compound particles were of rounded shapes compared with before the heat treatment.

FIG. 7 is an enlarged photographic image of the inorganic compound particle (test number 4-05, which is explained later). FIG. 8 shows the state of the surface of the inorganic compound particle. As shown in this figure, the surface of the inorganic compound particle was not smooth, and a number of spiky micro protrusions were observed.

FIG. 9 shows a composition image of a cross section of the inorganic compound particles (test number 4-02, which is explained later) obtained by polishing the particles after embedding the inorganic compound particles, which were subjected to the heat treatment at 870°C for 2 hours, in a resin.

In the composition image, particles of two kinds were observed that are uniformly grey in their entire cross sections, and a multi-layer structure wherein the central part was white and the outer peripheral part was grey.

In the composition image, a difference in colors means there is a difference in the average molecular weight, indicating compositions were different. Thus, characteristic X-ray images of Si and Mg were obtained by an X-ray spectrometer using an energy dispersive X-ray spectrometer in order to investigate the uniformity of the inorganic compound particles.

FIG. 10 is a composition image of a cross section of the particles of an inorganic compound having the multi-layered structure. The central part was white, and the outer peripheral part was grey. FIG. 11 is a Si characteristic X-ray image of the particle. In this image, the high Si concentration is the white, the low concentration is the grey color. FIG 12 is an Mg characteristic X-ray image.

By the Mg characteristic X-ray image, it was demonstrated that Mg exists in the outer peripheral part, and Mg hardly exists in the central part. Additionally, by the Si characteristic X-ray image, it was demonstrated that Si concentration was high in the central part and it was low in the outer peripheral part.

Based on these observations, it was demonstrated that the outer peripheral part was made of the composite (Mg₂Si) and the central part was made of Si alone. This indicates that the synthetic reaction did not proceed to the central part. The extent of this synthetic reaction can be stimulated to the central part by a longer heat treatment time.

FIG. 13 is a composition image of a particle, a cross-section of which was uniformly grey over the entire cross section. FIG. 14 is an Mg characteristic X-ray image. FIG. 15 is a Si characteristic X-ray image. For both the characteristic X-ray images of Mg and Si, the cross-sections had a uniform color over the entire cross-section. Therefore, it was demonstrated that these particles had a uniform composition over the entire cross-section.

The yields for each particle were measured after sieve classifying the produced single phase under each heat treatment condition. The yields are shown as percentage (mass percentage).

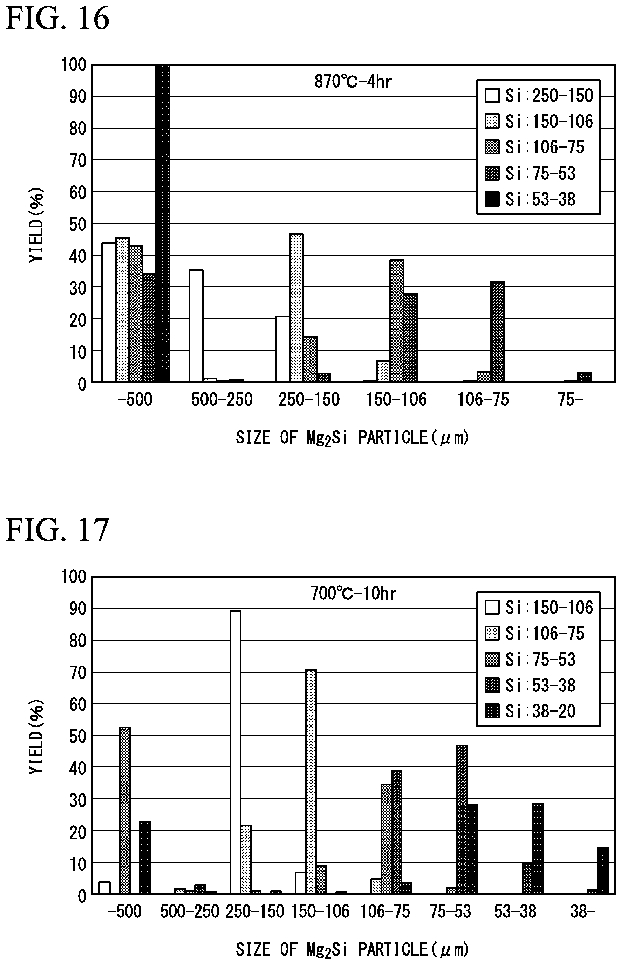

FIG. 16 shows yields of inorganic compound particles when the heat treatment was performed at 870°C for 4 hours using Mg particles having a particle size of about 3 to 8 mm.

When the particle size of the Si particles was 106µm or less, at least part of the compound (product) became a large block form. The yield of block form was 43.0% when the size of the Si particles was more than 75µm and 106µm or less. The yield of block form was 34.0% when the size of the Si particles was more than 53µm and 75µm or less. The yield of block form was 100% when it was 53µm or less.

Based on these results, it was demonstrated that inorganic compounds of a particle shape cannot be obtained when the particle size of Si particles is 53µm or less.

As shown in FIG. 16, when the particle size of the Si particles was 106µm or more, the yield of the inorganic compound particles having a particle size of 500µm or more was 43.7% where the particle size of the Si particles was more than 150µm and 250µm or less, and was 45.2% where the size of the Si particles was more than 106µm and 150µm or less.

When using Si particles having particle sizes of more than 150µm and 250µm or less, the yield of the inorganic compound particles having a particle size of more than 250µm and 500µm or less was 35.3%, the yield of the inorganic compound particles having a particle size of more than 150µm and 250µm or less was 20.6%, the yield of the inorganic compound particles having a particle size of more than 106µm and 150µm or less was 0.4%, the yield of the inorganic compound particles having a particle size of more than 75µm and 106µm or less was 0.06%, and the yield of the inorganic compound particles having a particle size of 75µm or less was 0.02%.

When using Si particles having particle sizes of more than 106µm and 150µm or less, the yield of the inorganic compound particles having a particle size of more than 250µm and 500µm or less was 1.2%, the yield of the inorganic compound particles having a particle size of more than 150µm and 250µm or less was 46.7%, the yield of the inorganic compound particles having a particle size of more than 106µm and 150µm or less was 6.6%, the yield of the inorganic compound particles having a particle size of more than 75µm and 106µm or less was 0.3% , and the yield of the inorganic compound particles having a particle size of 75µm or less was 0.05%.

When using Si particles having particle sizes of more than 75µm and 106µm or less, the yield of the inorganic compound particles having a particle size of more than 250µm and 500µm or less was 0.6%, the yield of the inorganic compound particles having a particle size of more than 150µm and 250µm or less was 14.5%, the yield of the inorganic compound particles having a particle size of more than 106µm and 150µm or less was 38.4%, the yield of the inorganic compound particles having a particle size of more than 75µm and 106µm or less was 3.3%, and the yield of the inorganic compound particles having a particle size of 75µm or less was 0.3%.

When using Si particles having particle sizes of more than 53µm and 75µm or less, the yield of the inorganic compound particles having a particle size of more than 250µm and 500µm or less was 0.7%, the yield of the inorganic compound particles having a particle size of more than 150µm and 250µm or less was 2.8%, the yield of the inorganic compound particles having a particle size of more than 106µm and 150µm or less was 27.8%, the yield of the inorganic compound particles having a particle size of more than 75µm and 106µm or less was 31.7%, and the yield of the inorganic compound particles having a particle size of 75µm or less was 3.0%.

Based on these results, it was demonstrated that a large number of the single-phase inorganic compound particles were obtained with a larger particle size than that of the used Si particles. Also, a small number of the inorganic compound particles were obtained with a smaller particle size than that of the used Si particles.

It was also demonstrated that 80 % or more of the entire inorganic compound particles was occupied by the inorganic compound particles having a larger particle size than that of the used Si particles, and the block object. This accounted for the inorganic compound particles of the other particle size being very few.

In FIGS. 16, 17 and 21, the block object was indicated as "-500." Similarly, the size of more than 250µm and 500µm or less, the size of more than 150µm and 250µm or less, the size of more than 106µm and 250µm or less, the size of more than 75µm and 106µm or less, and the size of more than 53µm and 75µm or less, was indicated as "500-250", "250-150", "150-106", "106-75", and "75-53", respectively. Similarly, the size of 75µm or less, the size of more than 38µm and 75µm or less, and the size of 38µm or less, was indicated as "75-", "53-38", and "38-.", respectively.

When the heat treatment was performed at 870°C for 4 hours using Mg particles having a particle size of about 1 to 3mm, the yield of the single-phase inorganic compound particle increased compared with the case of using Mg particles having a particle size of about 3 to 8mm.

When using Si particles having particle sizes of more than 150µm and 250µm or less, the block object which sintered together each particle accounted for 12.6%. The yield of the Mg₂Si compound particles having a particle size of more than 250µm and 500µm or less was 59.9%, the yield of the Mg₂Si compound particles having a particle size of more than 150µm and 250µm or less was 26.9%, the yield of the Mg₂Si compound particles having a particle size of more than 106µm and 150µm or less was 0.5%, the yield of the Mg₂Si compound particles having a particle size of more than 75µm and 106µm or less was 0.03%, and the yield of the Mg₂Si compound particles having a particle size of 75µm or less was 0.04%.

When using Si particles having particle sizes of more than 106µm and 150µm or less, the block object which sintered together each particle was accounted for 8.4%. The yield of the Mg₂Si compound particles having a particle size of more than 250µm and 500µm or less was 3.3%, the yield of the Mg₂Si compound particles having a particle size of more than 150µm and 250µm or less was 74.0%, the yield of the Mg₂Si compound particles having a particle size of more than 106µm and 150µm or less was 13.7%, the yield of the Mg₂Si compound particles having a particle size of more than 75µm and 106µm or less was 0.5%, and the yield of the Mg₂Si compound particles having a particle size of 75µm or less was 0.08%.

Based on these results, it was demonstrated that the particle size of the Mg particles affected the yield drastically. A higher yield was obtained when the Mg particle size was about 1 to 3mm compared with the Mg particle size of about 3 to 8mm.

FIG. 17 shows yields of inorganic compound particles when the heat treatment was performed at 700°C for 10 hours using Mg particles having a particle size of about 1 to 3mm.

The yield of the block object was 3.5% where the particle size of the Si particle was more than 106µm and 150µm or less, was 0% where the Si particle size was more than 75µm and 106µm or less, was 56.6% where the Si particle size was more than 53µm and 75µm or less, was 0% where the Si particle size was more than 38µm and 53µm or less, and was 23.1% where the Si particle size was more than 20µm and 38µm or less.

Based on these results, it was demonstrated that only particles were obtained and the block object was not produced if the particle size of the Mg particles has been set to about 1 to 3mm and the heat treatment temperature has been set at a low level.

Depending on the particle size of the Si particles, the block object still could have been formed. However, the compounds in a granular form were obtained even if the particle size of the Si particles was more than 20µm and 38µm or less in the present test condition (the heat treatment temperature: 700°C), compared to the case wherein the compound became the block form altogether where the particle size of the Si particles was less than 53µm at the heat treatment temperature of 870 °C.

When using Si particles having particle sizes of more than 106µm and 150µm or less, the yield of the inorganic compound particles having a particle size of more than 250µm and 500µm or less was 0%, the yield of the inorganic compound particles having a particle size of more than 150µm and 250µm or less was 89.4%, the yield of the inorganic compound particles having a particle size of more than 106µm and 150µm or less was 7.1%, the yield of the inorganic compound particles having a particle size of more than 75µm and 106µm or less was 0.05%, and the yield of the inorganic compound particles having a particle size of 75µm or less was 0.04%.

When using Si particles having particle sizes of more than 75µm and 106µm or less, the yield of the inorganic compound particles having a particle size of more than 250µm and 500µm or less was 1.9%, the yield of the inorganic compound particles having a particle size of more than 150µm and 250µm or less was 21.9%, the yield of the inorganic compound particles having a particle size of more than 106µm and 150µm or less was 70.9%, the yield of the inorganic compound particles having a particle size of more than 75µm and 106µm or less was 5.1%, and the yield of the inorganic compound particles having a particle size of 75µm or less was 0.3%.

When using Si particles having particle sizes of more than 53µm and 75µm or less, the yield of the inorganic compound particles having a particle size of more than 250µm and 500µm or less was 0.7%, the yield of the inorganic compound particles having a particle size of more than 150µm and 250µm or less was 0.8%, the yield of the inorganic compound particles having a particle size of more than 106µm and 150µm or less was 16.2%, the yield of the inorganic compound particles having a particle size of more than 75µm and 106µm or less was 24.3%, and the yield of the inorganic compound particles having a particle size of 75µm or less was 2.3%.

When using Si particles having particle sizes of more than 38µm and 53µm or less, the yield of the inorganic compound particles having a particle size of more than 250µm and 500µm or less was 3.0%, the yield of the inorganic compound particle having a particle size of more than 150µm and 250µm or less was 0.3%, the yield of the inorganic compound particle having a particle size of more than 106µm and 150µm or less was 0.2%, the yield of the inorganic compound particle having a particle size of more than 75µm and 106µm or less was 38.9%, the yield of the inorganic compound particle having a particle size of more than 53µm and 75µm or less was 46.7%, the yield of the inorganic compound particle having a particle size of more than 38µm and 53µm or less was 9.4%, and the yield of the inorganic compound particle having a particle size of 38µm or less was 1.6%.

When using Si particles having particle sizes of more than 20µm and 38µm or less, the yield of the inorganic compound particles having a particle size of more than 250µm and 500µm or less was 0.9%, the yield of the inorganic compound particles having a particle size of more than 150µm and 250µm or less was 0.7%, the yield of the inorganic compound particles having a particle size of more than 106µm and 150µm or less was 0.4%, the yield of the inorganic compound particles having a particle size of more than 75µm and 106µm or less was 3.7%, the yield of the inorganic compound particles having a particle size of more than 53µm and 75µm or less was 28.5%, the yield of the inorganic compound particles having a particle size of more than 38µm and 53µm or less was 28.5%, and the yield of the inorganic compound particles having a particle size of 38µm or less was 14.5%.

As shown above, the yield of the inorganic compound particles was drastically increased when they were synthesized under the condition where the temperature of the heat treatment was 700°C for 10 hours and Mg particles having a particle size of about 1 to 3mm were used. The maximum yield was 89.4%.

Based on these results, it was demonstrated that the inorganic compound particles could be produced efficiently at a temperature between the eutectic temperature, 637.6°C, of the region-I and the region-II and the eutectic temperature, 950°C, of the region-III and the region-IV of the Mg-Si phase diagram shown in FIG. 18. Also, it was demonstrated that the yield of the inorganic compound particles was high if the temperature was in the neighborhood of 650°C, which is the melting point of Mg, and the particle size of the Mg particles was around 3mm (i.e., 1 to 3mm).

**[TABLE 4]**

| No. | Raw-material particle | | | | Heating treatment | | Inorganic compound | | | | | | | |
|---|---|---|---|---|---|---|---|---|---|---|---|---|---|---|
| | First | | Second | | Temp. | Time | Shape | Composition | Yield (wt%) | | | | | |
| | | Size | | Size | °C | hr | A* | B* | 51* | 50* | 25* | 15* | 10* | 7* |
| 4-01 | Si | 250* | Mg | 6* | 870 | 2 | o | Mg₂Si+Si | 7.7 | 50.3 | 41.3 | 0.6 | 0.06 | 0.1 |
| 4-02 | Si | 150* | Mg | 6* | 870 | 2 | o | Mg₂Si+Si | 7.2 | 9.1 | 76.4 | 7 | 0.06 | 0.25 |
| 4-03 | Si | 250* | Mg | 6* | 870 | 4 | o | Mg₂Si | 43.7 | 35.3 | 20.6 | 0.4 | 0.06 | 0.02 |
| 4-04 | Si | 150* | Mg | 6* | 870 | 4 | o | Mg₂Si | 45.2 | 1.2 | 46.7 | 6.6 | 0.3 | 0.05 |
| 4-05 | Si | 106* | Mg | 6* | 870 | 4 | o | Mg₂Si | 43 | 0.6 | 14.5 | 38.4 | 3.3 | 0.3 |
| 4-06 | Si | 75* | Mg | 6* | 870 | 4 | o | Mg₂Si | 34 | 0.7 | 2.8 | 27.8 | 31.7 | 3 |
| 4-07^{#} | Si | 53* | Mg | 6* | 870 | 4 | Unclear | Mg₂Si | 100 | 0 | 0 | 0 | 0 | 0 |
| 4-08^{#} | Si | 38* | Mg | 6* | 870 | 4 | Unclear | Mg₂Si | 100 | 0 | 0 | 0 | 0 | 0 |
| 4-09 | Si | 150* | Mg | 6* | 700 | 10 | o | Mg₂Si | 3.48 | 0 | 89.4 | 7.1 | 0.05 | 0.04 |
| 4-10 | Si | 106* | Mg | 6* | 700 | 10 | o | Mg₂Si | 0.9 | 32.7 | 24.7 | 39 | 2.4 | 0.2 |
| 4-11 | Si | 250* | Mg | 3* | 870 | 4 | o | Mg₂Si | 12.6 | 59.9 | 26.9 | 0.5 | 0.03 | 0.04 |
| 4-12 | Si | 150* | Mg | 3* | 870 | 4 | o | Mg₂Si | 8.4 | 3.3 | 74 | 13.7 | 0.52 | 0.08 |
| 4-13^{#} | Si | 38* | Mg | 3* | 870 | 4 | Unclear | Mg₂Si | 100 | 0 | 0 | 0 | 0 | 0 |
| 4-14 | Si | 150* | Mg | 3* | 700 | 10 | o | Mg₂Si | 3.5 | 0 | 89.4 | 7.1 | 0.05 | 0.04 |
| 4-15 | Si | 106* | Mg | 3* | 700 | 10 | o | Mg₂Si | 0 | 1.9 | 21.9 | 70.9 | 5.1 | 0.25 |
| 4-16 | Si | 75* | Mg | 3* | 700 | 10 | o | Mg₂Si | 56.6 | 0.7 | 0.8 | 16.2 | 24.3 | 2.3 |
| 4-17^{#} | Si | 53* | Mg | 3* | 700 | 10 | o | Mg₂Si | 0 | 3 | 0.25 | 0.16 | 38.9 | 57.7 |
| 4-18^{#} | Si | 38* | Mg | 3* | 700 | 10 | o | Mg₂Si | 23.1 | 0.89 | 0.72 | 0.38 | 3.7 | 71.26 |
| 4-19^{#} | Si | 1* | Mg | 3* | 700 | 10 | Unclear | Mg₂Si | 100 | 0 | 0 | 0 | 0 | 0 |
| 4-20^{#} | Si | 1000* | Mg | 6* | 900 | 10 | o | Mg₂Si+Si | 100 | 0 | 0 | 0 | 0 | 0 |
| 6*: Particle size is 3-8mm. | | | | | 53*: Particle size is 38-53(µm*). | | | | | | | 51*: Block form in which particles are sintered together. | | |
| 3*: Particle size is 1-3mm. | | | | | 38*: Particle size is 20-38(µm*). | | | | | | | | | |
| µm*: Lower limit indicates "more than" and upper limit indicates "equals to or less." | | | | | 20*: Particle size is 20µm or less. | | | | | | | | | |
| | | | | | 1*: Particle size is 1µm or less. | | | | | | | 50*: Particle size is 250-500(µm*). | | |
| | | | | | A*: Presence or absence of a surface having the raised fabric shape: o; present, x; absent. | | | | | | | | | |
| 1000*: Particle size is 0.5-1mm. | | | | | | | | | | | | 25*: Particle size is 150-250(µm*). | | |
| 250*: Particle size is | | | | | B*: Composition and uniformity of the inorganic compound particles. Only one composition is indicated. When the particle is uniform, only one composition is indicated. When the particle has a layered-structure, two compositions are indicated: the one on the left shows the composition of the outer peripheral layer; the one on the right shows the composition of the central part. | | | | | | | | | |
| 150-250(µm*). | | | | | | | | | | | | 15*: Particle size is 106-150(µm*). | | |
| 150*: Particle size is | | | | | | | | | | | | | | |
| 106-150(µm*). | | | | | | | | | | | | 10*: Particle size is 75-106(µm*). | | |
| 106*: Particle size is | | | | | | | | | | | | | | |
| 75-106(µm*). | | | | | | | | | | | | 7*: Particle size is 75µm or less. | | |
| | | | | | | | | | | | | | | |

| | | | | | | | | | | | | | | |
|---|---|---|---|---|---|---|---|---|---|---|---|---|---|---|
| ^{#} Not within scope of present invention | | | | | | | | | | | | | | |

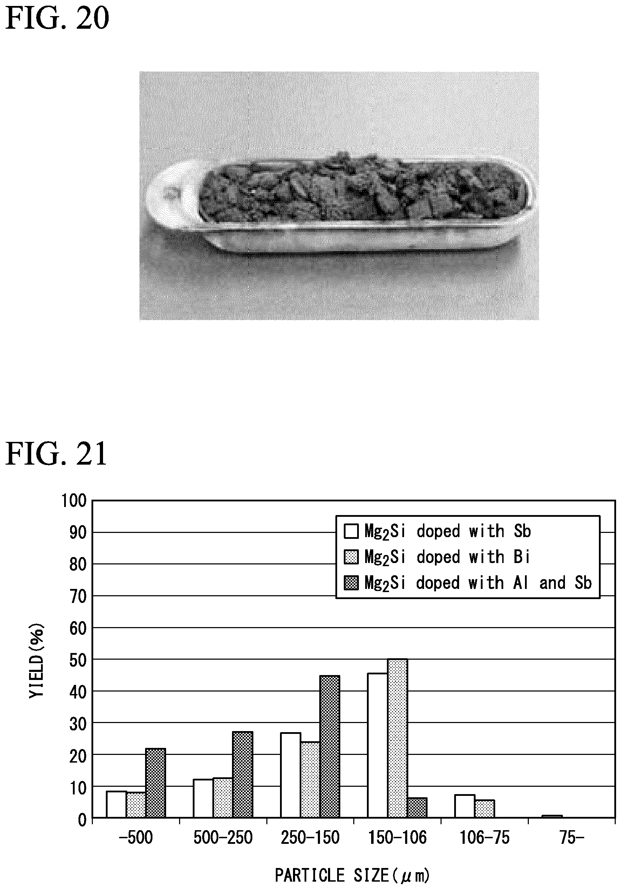

FIG. 20 is a photographic image of the compound obtained in the testnumber 4-19 (not according to present invention). In this test, compounds in a block form were obtained, instead of compounds in a granular form.

### [EXAMPLE 2]

The first raw-material particles (Si particles), which are made of Si (purity: 99.9999%), and the second raw-material particles (Mg granules), which are made of Mg (purity: 99.9%), were prepared.

The Si particles were classified by using sieves. Si particles which had particle sizes of more than 106µm and 150µm or less and particle sizes of more than 75µm and 106µm or less were prepared.

The Mg particles having a particle size of about 1 to 3mm were prepared.

As the additional elements, antimony (Sb) powder having a particle size of more than 75µm and 250µm or less (purity: 99.99%), bismuth (Bi) particles having a particle size of about 1 to 3mm (purity: 99.999%), and aluminum (Al) particles having a particle size of more than 75µm and 150µm or less (purity: 99.9%) were prepared.

The above-mentioned particles were weighed to obtain inorganic compound having compositions of Mg_{2.02}Si_{0.99}Sb_{0.01}, Mg_{2.02}Si_{0.99}Bi_{0.01}, and Mg_{2.01}Al_{0.01}Si_{0.99}Sb_{0.01}.

As shown in FIG. 1, the Mg particles 2 were placed evenly all over the bottom surface of the heating container 10 (carbon board). Then, as shown in FIG. 2, the Si particles and other additional elements (Si, Sb, Bi, and Al) 1 were placed on the Mg particles 2 to cover the Mg particles 2. Then, the heating container 10 was placed in the heating furnace to perform heat treatment under the mixed gas atmosphere of 0.1 MPa argon-3% hydrogen. The heat treatment temperature was set to 800°C. The heat treatment time was set to 4 hours.

A visual inspection, a sieve classification, and a phase analysis by X-ray diffraction was performed. Also, shape and surface observation, and composition analysis were performed by a scanning electron microscope. Results are shown in Table 5.

FIG. 21 is a graph showing the yields of the compound particles.

As shown in FIG. 21, for the test number 5-01, the compound particle made of Mg₂Si doped with Sb (composition formula: Mg₂Si_{0.99}Sb_{0.01}) was obtained, and the yield of the compound particles having a particle size of more than 250µm and 500µm or less was 12.2%, the yield of the compound particles having a particle size of more than 150µm and 250µm or less was 26.7%, the yield of the compound particles having a particle size of more than 106µm and 150µm or less was 45.2%, the yield of the compound particles having a particle size of more than 75µm and 106µm or less was 7.1%, and the yield of the compound particles having a particle size of 75µm or less was 0.5%.

For the test number 5-02, the compound particle made of Mg₂Si doped with Bi (composition formula: Mg₂Si_{0.99}Bi_{0.01}) was obtained, and the yield of the compound particles having a particle size of more than 250µm and 500µm or less was 12.5%, the yield of the compound particles having a particle size of more than 150µm and 250µm or less was 23.9%, the yield of the compound particles having a particle size of more than 106µm and 150µm or less was 50.1%, the yield of the compound particles having a particle size of more than 75µm and 106µm or less was 5.4%, and the yield of the compound particles having a particle size of 75µm or less was 0.4%.

In the case where Sb was doped (test number 5-01), and in the case where Bi was doped (test number 5-02), the yields of the compound particles were at almost the same level, since the particle size of the Si particles (more than 75µm and 106µm or less) was the same and the heat treatment conditions were the same.

In the test number 5-03, in which the compound particle made of Mg₂Si doped with Sb and Al (composition formula: Mg_{1.99}Al_{0.01}Si_{0.99}Bi_{0.01}) was obtained, the block object, in which the compound particles were adhered together, accounted for 21.8%. The yield of the compound particles having a particle size of more than 250µm and 500µm or less was 26.8%, the yield of the compound particles having a particle size of more than 150µm and 250µm or less was 44.8%, the yield of the compound particles having a particle size of more than 106µm and 150µm or less was 6.1%, the yield of the compound particles having a particle size of more than 75µm and 106µm or less was 0.3%, and the yield of the compound particles having a particle size of 75µm or less was 0.2%.

The particle size of the Si particles in the test number 5-03 was larger compared with the test numbers 5-01 and 5-02 (more than 106µm and 150µm or less). Therefore, the highest yield of the compound particles was obtained for compound particles havinga particle size of more than 150µm and 250µm or less.

Based on the results, it was demonstrated that the compound particles could be obtained easily if the third element (dopant element) was doped in addition to Mg and Si.

**[TABLE 5]**

| No. | Raw particle | | | | | | Heat treatment | | Inorganic compound | | | | | | |
|---|---|---|---|---|---|---|---|---|---|---|---|---|---|---|---|
| | First | | Second | | Supplemented element | | Temp. | Time | Composition | Yield (wt%) | | | | | |
| | | Size | | Size | | | °C | hr | B* | 51* | 50* | 25* | 15* | 10* | 7* |
| 5-01 | Si | 106* | Mg | 3* | Sb | | 800 | 4 | Mg₂Si_{0.99}Sb_{0.01} | 8.3 | 12.2 | 26.7 | 45.2 | 7.1 | 0.5 |
| 5-01 | Si | 106* | Mg | 3* | Bi | | 800 | 4 | Mg₂Si_{0.99}Bi_{0.01} | 7.8 | 12.5 | 23.9 | 50.1 | 5.4 | 0.4 |
| 5-03 | Si | 150* | Mg | 3* | Sb | Al | 800 | 4 | Mg_{1.99}Al_{0.01}Si_{0.99}Bi_{0.01} | 21.8 | 26.8 | 44.8 | 6.1 | 0.3 | 0.2 |
| 3*: Particle size is 1-3mm | | | | | | | | | | 51*: Block form. | | | | | |
| µm*: Lower limit indicates "more than" and upper limit indicates "equals to or less" in µm. | | | | | | | | | | 50*: Particle size is 250-500(µm*). | | | | | |
| | | | | | | | | | | 25*: Particle size is 150-250(µm*). | | | | | |
| | | | | | | | | | | 15*: Particle size is 106-150(µm*). | | | | | |
| 150*: Particle size is 106-150(µm*). | | | | | | | | | | 10*: Particle size is 75-106(µm*). | | | | | |
| 106*: Particle size is 75-106(µm*). | | | | | | | | | | 7*: Particle size is 75µm or less. | | | | | |

### INDUSTRIAL APPLICABILITY

The inorganic compound particles obtained by the present invention can be utilized for a dispersion agent to improve mechanical strength of Mg alloy materials which are light-weight construction materials. Also, sintered compacts of the inorganic compound particles can be used as a thermoelectric material.

### BRIEF DESCRIPTION OF THE REFERENCE SYMBOLS

1: Si particle (first raw-material particle)
2: Mg particle (second raw-material particle)

## Claims

1. A method of producing inorganic compound particles which are a composite including Si and Mg, the method comprising the steps of:
heating a raw material comprising (i) first raw-material particles comprising Si as a major element, and (ii) second raw-material particles comprising Mg as a major element, at a temperature equal to or higher than 650°C and lower than 945.6°C, thereby impregnating a melt liquid of the second raw-material particles into the first raw-material particles; and
synthesizing the inorganic compound particles through a synthesis reaction between the elements comprised in said first and second raw-materials particles which takes place in the first raw-material particles, wherein
the first raw-material particles and the second raw-material particles are mixed in the raw material in an atomic ratio corresponding to the atomic ratio of the said major element, Si, and the said major element, Mg, within the inorganic compound particles,
the inorganic compound particles are represented by the formula Mg₍₂₋ₓ₎A₍ₓ₎Si_{(1-y)}A'_{y} where A and A' are different one or more dopant elements as defined below and x+y is equal to or less than 0.2,
the particle size of the first raw-material particles is greater than 53µm and less than 500µm,
the dopant elements are selected from the group consisting of B, P, Al, Sb, and Bi and are added to the first raw-material particles, and
the particle size of the inorganic compound particles is greater than 25µm and equal to or less than 1mm after the step of synthesizing the inorganic compound particles.

2. The method of producing inorganic compound particles according to Claim 1,
wherein the first raw-material particles are a mixture of plural types of particles which consist of different elements.

3. The method of producing inorganic compound particles according to Claim 1,
wherein the first raw-material particles are a composite of particles which consist of different elements.

4. The method of producing inorganic compound particles according to Claim 1, wherein three or more dopant elements selected from the group consisting of B, P, Al, Sb, and Bi are added to the first raw-material particles.

5. An inorganic compound particle obtained by the method of Claim 1,
wherein the surface of the inorganic compound particle is covered by protuberances in a raised fabric shape, which protuberances are minute relative to the particle size of the inorganic compound particle.

6. The inorganic compound particle according to Claim 5,
wherein the particle has a bi-layer structure with a central part and an outer peripheral part, wherein the element constituting the first raw-material particles is the major constituent element of said central part, and the elements constituting the first and second raw-material particles are the major constituent elements of said outer peripheral part.

7. The inorganic compound particle according to Claim 5,
wherein the inorganic compound particle has a uniform composition extending from an outer peripheral part to a central part in the inorganic compound particle.

## Patentansprüche

1. Verfahren zur Herstellung anorganischer Verbundpartikel, die ein Verbund sind, der Si und Mg enthält, das Verfahren umfassend die Schritte von:
Erwärmen eines Rohstoffs, umfassend (i) erste Rohstoffpartikel, die Si als Hauptelement umfassen, und (ii) zweite Rohstoffpartikel, die Mg als Hauptelement umfassen, bei einer Temperatur gleich oder höher als 650 °C und niedriger als 945,6 °C, wodurch eine Schmelzflüssigkeit der zweiten Rohstoffpartikel in die ersten Rohstoffpartikel imprägniert wird; und
Synthetisieren der anorganischen Verbundpartikel durch eine Synthesereaktion zwischen den Elementen, umfasst in den ersten und zweiten Rohstoffpartikeln, das in den ersten Rohstoffpartikeln stattfindet, wobei
die ersten Rohstoffpartikel und die zweiten Rohstoffpartikel werden in dem Rohstoff in einem Atomverhältnis gemischt, entsprechend dem Atomverhältnis des Hauptelements, Si, und des Hauptelements, Mg, innerhalb der anorganischen Verbundpartikel, die anorganischen Verbundpartikel durch die Formel Mg₍₂₋ₓ₎A₍ₓ₎Si_{(1-y)}A'_{y} dargestellt werden, wobei A und A' ein oder mehrere verschiedene Dotierstoffelemente wie nachstehend definiert sind und x+y gleich oder kleiner als 0,2 ist,
die Partikelgröße der ersten Rohstoffpartikel größer als 53 µm und kleiner als 500 µm ist,
die Dotierstoffelemente aus der Gruppe ausgewählt sind, bestehend aus B, P, Al, Sb und Bi und zu den ersten Rohstoffpartikeln hinzugefügt werden, und
die Partikelgröße der anorganischen Verbundpartikel größer als 25 µm und gleich oder kleiner als 1 mm nach dem Schritt des Synthetisierens der anorganischen Verbundpartikel ist.

2. Verfahren zur Herstellung anorganischer Verbundpartikel nach Anspruch 1,
wobei die ersten Rohstoffpartikel eine Mischung aus mehreren Arten von Partikeln sind, die aus verschiedenen Elementen bestehen.

3. Verfahren zur Herstellung anorganischer Verbundpartikel nach Anspruch 1,
wobei die ersten Rohstoffpartikel ein Verbund von Partikeln sind, die aus verschiedenen Elementen bestehen.

4. Verfahren zur Herstellung anorganischer Verbundpartikel nach Anspruch 1,
wobei drei oder mehr Dotierstoffelemente, ausgewählt aus der Gruppe, bestehend aus B, P, Al, Sb und Bi, zu den ersten Rohstoffpartikeln hinzugefügt werden.

5. Anorganische Verbundpartikel, erhalten durch das Verfahren nach Anspruch 1,
wobei die Oberfläche des anorganischen Verbundpartikels durch Vorsprünge in einer erhöhten Gewebeform bedeckt ist, wobei die Vorsprünge relativ zur Partikelgröße des anorganischen Verbundpartikels winzig sind.

6. Anorganisches Verbundpartikel nach Anspruch 5,
wobei das Partikel eine zweischichtige Struktur mit einem zentralen Teil und einem äußeren peripheren Teil aufweist, wobei das die ersten Rohstoffpartikel bildende Element das Hauptbestandteilelement des zentralen Teils ist und die Elemente, die die ersten und die zweiten Rohstoffpartikel bilden, die Hauptbestandteilelemente des äußeren peripheren Teils sind.

7. Anorganisches Verbundpartikel nach Anspruch 5,
wobei das anorganische Verbundpartikel eine einheitliche Zusammensetzung aufweist, die sich von einem äußeren peripheren Teil zu einem zentralen Teil in dem anorganischen Verbundpartikel erstreckt.

## Revendications

1. Procédé de production de particules de composés inorganiques qui consistent en un composite incluant du silicium et du magnésium, le procédé comprenant les étapes consistant à :
chauffer une matière première comprenant (i) des premières particules de matière première comprenant du silicium en tant qu'élément principal, et (ii) des secondes particules de matière première comprenant du magnésium en tant qu'élément principal, à une température égale ou supérieure à 650 °C et inférieure à 945,6 °C, en imprégnant ainsi les premières particules de matière première avec un liquide de fusion des secondes particules de matière première ; et
synthétiser les particules de composés inorganiques par une réaction de synthèse entre les éléments compris dans lesdites premières et secondes particules de matière première, qui a lieu dans les premières particules de matière première, dans lequel
on mélange dans la matière première les premières particules de matière première et les secondes particules de matière première en un rapport atomique correspondant au rapport atomique dudit élément principal, silicium, et dudit élément principal, magnésium, dans les particules de composés inorganiques,
les particules de composés inorganiques sont représentées par la formule Mg₍₂₋ₓ₎A₍ₓ₎Si_{(1-y)}A'_{y}, où A et A' consistent en un ou plusieurs élément(s) dopant(s) différents tel(s) que défini(s) ci-dessous et la somme x+y est égale ou inférieure à 0,2,
la taille de particule des premières particules de matière première est supérieure à 53 µm et inférieure à 500 µm,
les éléments dopants sont choisis dans l'ensemble constitué par B, P, Al, Sb, et Bi et sont ajoutés aux premières particules de matière première, et
la taille de particule des particules de composés inorganiques est supérieure à 25 µm et égale ou inférieure à 1 mm après l'étape consistant à synthétiser les particules de composés inorganiques.

2. Procédé de production de particules de composés inorganiques selon la revendication 1,
dans lequel les premières particules de matière première consistent en un mélange de plusieurs types de particules qui consistent en des éléments différents.

3. Procédé de production de particules de composés inorganiques selon la revendication 1,
dans lequel les premières particules de matière première consistent en un composite de particules qui consistent en des éléments différents.

4. Procédé de production de particules de composés inorganiques selon la revendication 1,
dans lequel on ajoute aux premières particules de matière première trois ou plus de trois éléments dopants, choisis dans l'ensemble constitué par B, P, Al, Sb, et Bi.

5. Particule de composés inorganiques obtenue par le procédé selon la revendication 1,
dans laquelle la surface de la particule de composés inorganiques est couverte de protubérances en une forme d'élément structural en saillie, lesquelles protubérances sont très petites par rapport à la taille de particule de la particule de composés inorganiques.

6. Particule de composés inorganiques selon la revendication 5,
où la particule a une structure bicouche avec une partie centrale et une partie périphérique externe, où l'élément constituant les premières particules de matière première est l'élément constituant principal de ladite partie centrale, et les éléments constituant les premières et secondes particules de matière première sont les éléments constituants principaux de ladite partie périphérique externe.

7. Particule de composés inorganiques selon la revendication 5,
où la particule de composés inorganiques a une composition uniforme s'étendant d'une partie périphérique externe à une partie centrale dans la particule de composés inorganiques.
